# EUROPÄISCHE PATENTSCHRIFT

(11) **EP 1 875 518 B1**
(45) Veröffentlichungstag und Bekanntmachung des Hinweises auf die Patenterteilung: **15.08.2018**
(21) Anmeldenummer: 06722773.6
(22) Anmeldetag: 11.04.2006
(51) Int. Cl.: H01L 33/00

(54) **LUMINESZENZKONVERSIONS-LED**
LUMINESCENCE CONVERSION LED
DIODE ELECTROLUMINESCENTE A CONVERSION DE LUMINESCENCE

(30) Priorität: 26.04.2005 DE 102005019376
(43) Veröffentlichungstag der Anmeldung: 09.01.2008
(73) Patentinhaber: OSRAM GmbH, 80807 München (DE); OSRAM Opto Semiconductors GmbH, 93055 Regensburg (DE)
(72) Erfinder: BRAUNE, Bert, 93173 Wenzenbach (DE); JERMANN, Frank, 86343 Königsbrunn (DE); STRAUSS, Jörg, 93051 Regensburg (DE)
(74) Vertreter: Epping - Hermann - Fischer
(86) Internationale Anmeldenummer: PCT/DE2006/000636
(87) Internationale Veröffentlichungsnummer: WO 2006/114077

(56) Entgegenhaltungen:
- EP-A2- 1 441 395
- EP-A2- 1 480 278
- WO-A1-99/50916
- US-A1- 2003 214 233
- US-A1- 2004 173 806
- US-A1- 2004 207 998
- US-B1- 6 717 353

## Beschreibung

### Technisches Gebiet

Die Erfindung geht aus von einer Lumineszenzkonversions-LED gemäß dem Oberbegriff des Anspruchs 1. Es handelt sich dabei insbesondere um eine LED mit hoher Effizienz der Konversion.

### Stand der Technik

Gemäß US-B 6 686 691 ist eine Lumineszenzkonversions-LED bekannt, bei der als primäre Lichtquelle ein blauer Chip verwendet wird. Eine Leuchtstoffschicht mit zwei Leuchtstoffen, die blau absorbieren und grün und rot emittieren, ist dem Chip vorgeschaltet. Dabei werden aber die zwei Leuchtstoffe im Harz homogen verteilt, was zu unerwünschten Effekten führt. Es ist damit nicht möglich, die beiden Kriterien "hohe Effizienz" und "gute Farbwiedergabe" gleichzeitig zu erfüllen. Um eine hohe Farbwiedergabe zu erreichen, muss entweder ein eigentlich zu kurzwelliger Grünleuchtstoff verwendet werden, der dann durch die starke Absorption des Rotleuchtstoff verschoben wird, oder der Rotleuchtstoff muss möglichst weit ins Langwellige verschoben werden. Beide Lösungen verringern die Effizienz bedingt durch die hohe Absorption im ersten Fall und den geringen visuellen Nutzeffekt des roten Strahlungsanteils im zweiten Fall.

Aus der WO 00/33390 ist eine Lumineszenzkonversions-LED bekannt, bei der als primäre Lichtquelle ein blauer Chip verwendet wird. Eine Leuchtstoffschicht mit zwei Leuchtstoffen, die blau absorbieren und grün und rot emittieren, ist dem Chip vorgeschaltet. Die beiden Leuchtstoffe können als Mischung oder als separate Schichten verwendet werden.

Aus der US-B 6 642 652 und US-B 6 696 703 ist jeweils eine Lumineszenzkonversions-LED bekannt, bei der als primäre Lichtquelle ein blauer Chip verwendet wird. Zwei Leuchtstoffschichten, die blau absorbieren und grün und rot emittieren, sind dem Chip vorgeschaltet. Dabei ist die rote Leuchtstoffschicht direkt auf dem Substrat angebracht und die grüne befindet sich direkt darüber.

Aus der US 2004/169181 ist eine Dünnfilm-LED mit Leuchtstoff bekannt.

### Darstellung der Erfindung

Es ist Aufgabe der vorliegenden Erfindung, eine Lumineszenzkonversions-LED gemäß dem Oberbegriff des Anspruchs 1 bereitzustellen, die eine hohe Konversionseffizienz besitzt.

Diese Aufgabe wird durch die kennzeichnenden Merkmale des Anspruchs 1 gelöst. Besonders vorteilhafte Ausgestaltungen finden sich in den abhängigen Ansprüchen.

Erfindungsgemäß wird ein Konzepts zur Herstellung einer LED mit zwei Leuchtstoffen bereitgestellt, deren gegenseitige Absorption der Leuchtstoffemission gegenüber einer Standard-Verguss-LED signifikant verringert ist. Das folgende applikationsbezogene Problem soll dadurch gelöst werden: Zur Herstellung einer LED mit einer sehr guten Farbwiedergabe ist es nötig, mehr als einen Leuchtstoff zu verwenden. Im Allgemeinen wird ein roter und ein grüner Leuchtstoff benötigt. Besonders bevorzugte Rotleuchtstoffe (vor allem bei einer blauen Primär-LED) sind Eu²⁺-aktivierte Verbindungen, wie (Sr,Ca)₂Si₅N₈:Eu²⁺ (rot) oder CaSiAlN₃:Eu²⁺. Diese Leuchtstoffe haben die Eigenschaft, dass ihre Absorption bis in den orangegelben Spektralbereich hinein reicht. Dabei nimmt die Absorption mit zunehmender Wellenlänge ab. Kombiniert man nun einen solchen roten Leuchtstoff mit einem grünen oder gelben Leuchtstoff in der Form, dass man beide Leuchtstoffe in einem Harz gleichmäßig dispergiert, so absorbiert der rote Leuchtstoff die Emission des grünen/gelben Leuchtstoffs. Dabei werden die kurzwelligen Anteile stärker absorbiert als die langwelligen. Die effektive Emission des grünen/gelben Leuchtstoffs wird langwelliger. Dieser Absorptionsprozess verschlechtert darüber hinaus die Effizienz der LED, da das absorbierte Licht nicht vollständig in rotes Lumineszenzlicht umgewandelt wird. Die meist unerwünschte Verschiebung der grünen bzw. gelben Emission resultiert i. allg. in einer schlechteren Farbwiedergabe, als man es ohne die Verschiebung erwarten würde.

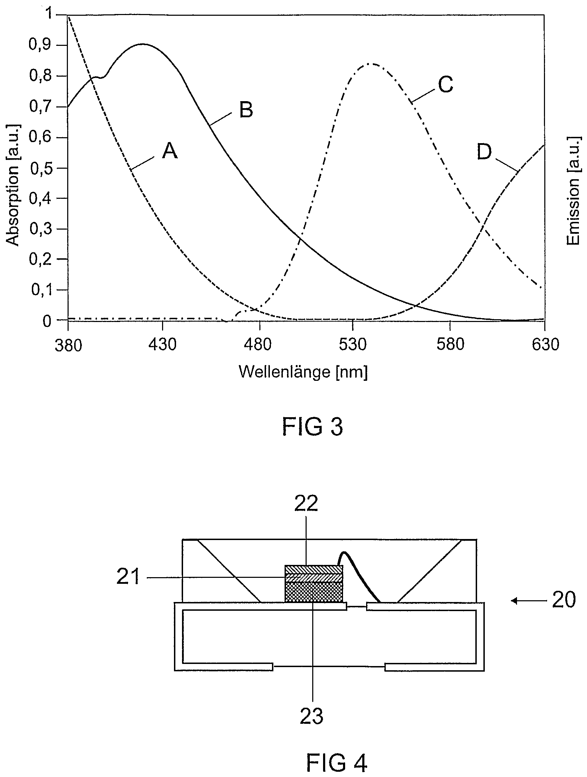

Ein naheliegender Lösungsansatz für das Problem besteht in der Herstellung einer Dünnfilm-LED 20, bei der wie in Figur 4 gezeigt, zunächst eine Schicht 21 Rotleuchtstoff und dann eine Schicht 22 Grünleuchtstoff auf den Chip 23 aufgebracht wird, ähnlich wie in US 6 686 691 beschrieben. Allerdings ist das Herstellverfahren in der Praxis nur schwer umzusetzen und führt zu starken Farbortschwankungen der hergestellten LEDs.

Mit dem erfindungsgemäßen Verfahren können dagegen hocheffiziente LEDs mit einer sehr guten Farbwiedergabe hergestellt werden, die noch dazu eine besonders homogene Abstrahlcharakteristik aufweisen.

Das erfindungsgemäße Verfahren besteht in der Aufbringung einer dünnen, bevorzugt höchstens 40 µm, insbesondere 10 bis 40 µm, dicken, chipnahen Schicht (bekannt als chip-level coating / on-chip coating) aus einem Rotleuchtstoff direkt auf den kurzwellig emittierenden Chip, der insbesondere eine Peakwellenlänge im Bereich 300 bis 480 nm, also im UV bis bevorzugt blauen Strahlungsbereich liegt, wobei die Schicht z. B. mittels Siebdruck oder Elektrophorese aufgebracht werden kann. Verschiedene Methoden dafür sind näher in US-B 6 686 691 beschrieben. Dieser so beschichtete Chip wird entweder direkt mit konverterbehaftetem Vergussharz vergossen oder in ein Standard-Gehäuse eingebracht und darin mit einem Harz, das nur den Grün- bzw. Gelbleuchtstoff beinhaltet, vergossen. Bei dieser Konfiguration ist die Wahrscheinlichkeit, dass grüne bzw. gelbe Strahlung des zweiten Leuchtstoffs den Rotleuchtstoff trifft, sehr viel geringer als bei einer homogenen Durchmischung der Leuchtstoffe. Der Vorteil ist, dass die Reabsorption abnimmt, während die Effizienz der LED steigt. Außerdem werden die Emissionsbanden besonders bevorzugter Leuchtstoffe wie Granate (z. B. (Y,Gd)₃(Al,Ga)₅O₁₂:Ce für gute Farbwiedergabe, Ra = 80+) bzw. Erdalkali-Oxinitridosilikate wie SrSi₂O₂N₂:Eu²⁺ (sehr gute Farbwiedergabe Ra = 85 und höher) kaum noch verschoben, so dass höhere Farbwiedergabeindizes Ra bei hohen Effizienzen erreicht werden.

Bevorzugt ist ein Design, bei dem ein Dünnfilmchip verwendet wird, wobei dieser mit integriertem Reflektor ausgestattet ist, so dass zurückgestreute Strahlung nicht verloren geht.

### Kurze Beschreibung der Zeichnungen

Im folgenden soll die Erfindung anhand mehrerer Ausführungsbeispiele näher erläutert werden. Es zeigen:
- Figur 1: ein Halbleiterbauelement, das als Lichtquelle (LED) für weißes Licht dient;
- Figur 2: ein weiteres Ausführungsbeispiel eines Halbleiterbauelements;
- Figur 3: eine schematische Darstellung des Absorptions- und Emissionsverhaltens des ersten und zweiten Leuchtstoffs;
- Figur 4: ein Ausführungsbeispiel eines Halbleiterbauelements gemäß Stand der Technik.

### Bevorzugte Ausführung der Erfindung

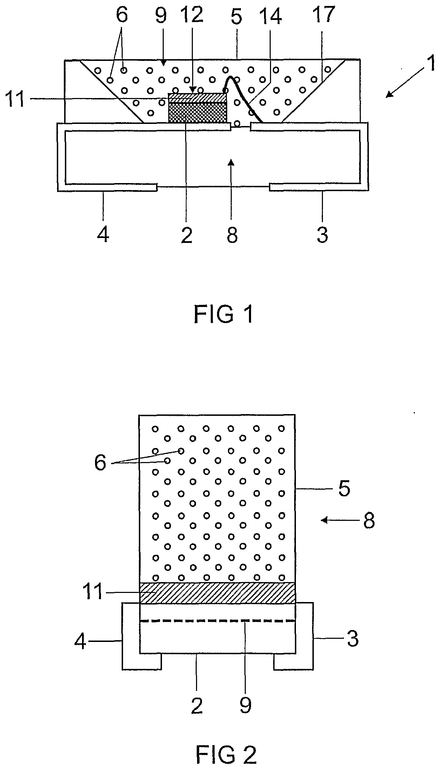

Für den Einsatz in einer weißen LED zusammen mit einem InGaN-Chip wird beispielsweise ein Aufbau grundsätzlich ähnlich wie in US 5 998 925 beschrieben verwendet. Der Aufbau einer derartigen Lichtquelle für weißes Licht ist in Figur 1 explizit gezeigt. Die Lichtquelle ist ein Halbleiterbauelement 1 mit einem Chip 2 des Typs InGaN mit einer Peak-Emissionswellenlänge von 460 nm, also im Blauen, mit einem ersten und zweiten elektrischen Anschluss 3,4, das in ein lichtundurchlässiges Grundgehäuse 8 im Bereich einer Ausnehmung 9 eingebettet ist. Einer der Anschlüsse 3 ist über einen Bonddraht 14 mit dem Chip 2 verbunden. Die Ausnehmung hat eine Wand 17, die als Reflektor für die blaue Primärstrahlung des Chips 2 dient. Der Rotleuchtstoff ist als dünne Schicht 11 auf den Chip direkt aufgebracht. Bevorzugt handelt es sich um ein Nitridosilikat des Typs MₓSi_{y}N_{z}:Eu; wobei M = Ca, Sr, Ba, Zn. Bevorzugt ist dabei z = 2/3x + 4/3y. Dieser Leuchtstoff ist an sich bekannt, beispielsweise aus EP 1 153 101 (Eu-rot-LED).

Die Schichtdicke sollte bevorzugt kleiner 40 µm sein, insbesondere etwa 10 bis 30 µm dick sein. Dies ist vorteilhaft, um sicherzustellen, dass die blaue Strahlung teilweise die Schicht 11 durchdringen kann. Die Ausnehmung 9 ist mit einer Vergussmasse 5 gefüllt, die als Hauptbestandteile Silikon und grün emittierende oder gelb emittierende Leuchtstoffpigmente 6 enthält. Diese Leuchtstoffpigmente sind in einer ersten Ausführungsform gelb emittierend, bevorzugt vom Typ Granat, beispielsweise YAG:Ce. Eine Alternative ist TbAG:Ce. Statt dessen können die Leuchtstoffpigmente auch grün emittierend sein, bevorzugt vom Typ Oxinitridosilikat. Ein konkretes Beispiel ist ein Erdalkali-SiON wie insbesondere SrSi₂O₂N₂:Eu²⁺, mit dem zusammen eine sehr gute Farbwiedergabe von Ra = 85 und mehr erreicht werden kann. Vorteilhaft ist die Dicke der Vergussmasse größer als 200 µm, insbesondere ist sie ca. 300 bis 500 µm, wobei der grüngelb emittierende zweite Leuchtstoff möglichst homogen darin verteilt ist. Um möglichst gleichmäßige Schichtdicken bei hoher Effizienz zu gewährleisten empfiehlt sich eine mittlere Korngröße d50, die unterhalb 15 µm liegen sollte, und die insbesondere im Bereich 5 bis 12 µm gewählt wird. Dieser Leuchtstoff ist an sich bekannt, beispielsweise aus EP-A 1449264.

Figur 2 zeigt eine alternative Ausführungsform eines Halbleiterbauelements 8, bei dem kein Gehäuse verwendet wird. Dabei sitzt die Vergussmasse 5 mit dem zweiten Leuchtstoff 6 ohne Gehäuse direkt auf dem Chip 2 und der ersten dünnen Schicht 11 des roten Leuchtstoffs auf. Im Chip 2 ist ein Reflektor 9 integriert, wie an sich bekannt, der jedoch im Zusammenhang mit dem erfindungsgemäß en Konzept der zwei Leuchtstoffe besonders vorteilhaft wirkt.

Dabei ist immer entscheidend, dass der rot emittierende Leuchtstoff, meist ein Nitridosilikat, die erste Schicht 11 bildet, die direkt auf dem Chip 2 aufgebracht ist, während der zweite Leuchtstoff 6, der grün emittiert, auf der ersten schmalen Schicht als zweite weiter entfernte Schicht im Vergussharz 5 aufgebracht ist.

Gemäß Figur 3 ist ein typisches Emissions- und Absorptionsverhalten von blau anregbaren Leuchtstoffen als Funktion der Wellenlänge gezeigt. Der exemplarische Rotleuchtstoff ist (Sr,Ca)2Si5N8:Eu, und der exemplarische Grünleuchtstoff ist Sr-Sion:Eu. Die Absorption B des roten Leuchtstoffs überlappt merklich mit der grünen Emission C. Die Absorption des grünen Leuchtstoffs A überlappt jedoch nicht mit der Emission D des Rotleuchtstoffs. Daher erhöht sich die Effizienz, wenn der rote Leuchtstoff direkt auf dem Chip aufgebracht wird, während der grün-gelbe Leuchtstoff das äußere weit verteilte Konversionselement bildet. Merklich bedeutet hier, daß sich die Effizienz um mindestens 2 % erhöht, wenn die beiden Leuchtstoff getrennt vor den Chip geschaltet werden anstatt in einer homogenen Mischung.

Ein weiteres System zweier Leuchtstoffe ist ein rot emittierendes Nitridosilikat zusammen mit einem grüngelb emittierenden Chlorosilikat. Geeignete Chlorosilikate sind beispielsweise aus DE-A 100 36 940 bekannt.

Dieses Prinzip kann auch angewendet werden, um spezielle Farben mit hoher Effizienz zu erzielen, die sich als Mischung aus rot und grün bis gelb emittierenden Leuchtstoffen herstellen lassen. In diesem Fall kann der Chip insbesondere auch UV-Strahlung emittieren.

Häufig haben UV-absorbierende und im Sichtbaren emittierende Leuchtstoffe die Eigenschaft, nur im UV zu absorbieren, so dass keine gegenseitige Absorption auftreten kann. Dies gilt insbesondere für Thiogallate und Sulfide. Blau absorbierende Leuchtstoffe neigen viel eher dazu, sich gegenseitig zu absorbieren, wie in Figur 3 dargestellt.

Typisch hat der erste rote Leuchtstoff eine Peakwellenlänge bei 590 bis 680 nm und weist eine Halbwertsbreite von 60 bis 130 nm auf. Typisch hat der zweite Leuchtstoff eine Peakwellenlänge bei 490 bis 580 nm und weist eine Halbwertsbreite von 30 bis 135 nm auf. Insbesondere wird als primäre Strahlungsquelle ein InGaN-Chip verwendet, dessen Peakwellenlänge bei 450 bis 470 nm liegt.

## Patentansprüche

1. Lumineszenzkonversions-LED mit einem strahlungsemittierenden Chip (2), wobei die primäre Strahlung des Chips UV bis blau ist und durch ein Konversionselement zumindest teilweise in längerwellige **sekundäre** Strahlung umgewandelt wird, und wobei das Konversionselement durch eine getrennte Anordnung zweier Leuchtstoffe gebildet wird, von denen ein erster Leuchtstoff **sekundär** rot emittiert und ein zweiter Leuchtstoff **sekundär** gelb bis grün emittiert, wobei der erste Leuchtstoff allein direkt auf dem Chip aufgebracht ist, **dadurch gekennzeichnet, dass die Schichtdicke des ersten Leuchtstoffs maximal 40 µm beträgt, und wobei der zweite Leuchtstoff in einer Vergussmasse dispergiert ist, die eine Schichtdicke von mindestens 200 µm besitzt.**

2. LED nach Anspruch 1, **dadurch gekennzeichnet, dass** der erste Leuchtstoff eine Peakwellenlänge bei 590 bis 680 nm hat und eine Halbwertsbreite von 60 bis 130 nm aufweist.

3. LED nach Anspruch 1, **dadurch gekennzeichnet, dass** der zweite Leuchtstoff eine Peakwellenlänge bei 490 bis 580 nm hat und eine Halbwertsbreite von 30 bis 135 nm aufweist.

4. LED nach Anspruch 1, **dadurch gekennzeichnet, dass** der Chip eine Peakwellenlänge bei 450 bis 470 nm aufweist.

5. LED nach Anspruch 1, **dadurch gekennzeichnet, dass** der Chip von einem Gehäuse umgeben ist, wobei der Chip (2) in einer Ausnehmung (5) des Gehäuses sitzt.

6. LED nach Anspruch 1, **dadurch gekennzeichnet, dass** der Chip aus dünnen Schichten besteht und insbesondere einen Reflektor für die emittierte Primär- und Sekundärstrahlung besitzt.

7. LED nach Anspruch 1, **dadurch gekennzeichnet, dass** die Absorption des roten Leuchtstoffs mit der Emission des grün-gelben Leuchtstoffs merklich überlappt.

## Claims

1. Luminescence conversion LED with a radiation-emitting chip (2), wherein the primary radiation of the chip is UV to blue and is at least partially converted by a conversion element into longer-wave secondary radiation, and wherein the conversion element is formed by a separate arrangement of two phosphors of which a first phosphor emits secondary red, and a second phosphor emits secondary yellow to green, wherein the first phosphor alone is applied directly on the chip **characterized in that**
the layer thickness of the first phosphor is not more than 40 µm, and wherein the second phosphor is dispersed in a casting compound having a layer thickness of at least 200 µm.

2. LED of claim 1, **characterized in that** the first phosphor has a peak wavelength at 590 to 680 nm and having a half-value width of 60 to 130 nm.

3. LED of claim 1, **characterized in that** the second phosphor has a peak wavelength at 490 to 580 nm and having a half-value width from 30 to 135 nm.

4. LED of claim 1, **characterized in that** the chip has a peak wavelength at 450 to 470 nm.

5. LED of claim 1, **characterized in that** the chip is surrounded by a housing, wherein the chip (2) is seated in a recess (5) of the housing.

6. LED of claim 1, **characterized in that** the chip consists of thin layers and in particular has a reflector for the emitted primary and secondary radiation.

7. LED of claim 1, **characterized in that** the absorption of the red phosphor overlaps significantly with the emission of the green-yellow phosphor.

## Revendications

1. DEL à conversion de luminescence dotée d'une puce (2) émettrice d'un rayonnement, le rayonnement primaire de la puce allant de l'ultraviolet au bleu et étant transformé au moins partiellement par un élément de conversion dans un rayonnement secondaire à ondes plus longues, et l'élément de conversion étant constitué par un agencement séparé de deux substances luminescentes, dont la première substance luminescente émet secondairement dans le rouge et une deuxième substance luminescence émet secondairement dans le jaune au vert, seule la première substance luminescente étant appliquée directement sur la puce, **caractérisée en ce que**
l'épaisseur de couche de la première substance luminescente est de 40 µm au maximum, et la deuxième substance luminescente étant dispersée dans une matière d'enrobage présentant une épaisseur de couche d'au moins 200 µm.

2. DEL selon la revendication 1, **caractérisée en ce que** la première substance luminescente a une longueur d'onde de pic de 590 à 680 nm et présente une largeur à mi-hauteur de 60 à 130 nm.

3. DEL selon la revendication 1, **caractérisée en ce que** la deuxième substance luminescente a une longueur d'onde de pic de 490 à 580 nm et présente une largeur de valeur moyenne de 30 à 135 nm.

4. DEL selon la revendication 1, **caractérisée en ce que** la puce présente une longueur d'onde de pic de 450 à 470 nm.

5. DEL selon la revendication 1, **caractérisée en ce que** la puce est entourée d'un boîtier, la puce (2) se trouvant dans une entaille (5) du boîtier.

6. DEL selon la revendication 1, **caractérisée en ce que** la puce est constituée de couches fines et possède notamment un réflecteur pour le rayonnement primaire et secondaire émis.

7. DEL selon la revendication 1, **caractérisée en ce que** l'absorption de la substance luminescente rouge se chevauche nettement avec l'émission de la substance luminescente verte-jaune.
